# EUROPEAN PATENT APPLICATION

(11) **EP 4 819 139 A1**
(43) Date of publication of application: **07.10.2026**
(21) Application number: 25706615.9
(22) Date of filing: 11.02.2025
(51) Int. Cl.: G11C 11/406, G11C 29/04

(54) **MEMORY SYSTEM AND OPERATION METHOD THEREFOR, AND CONTROLLER**

(71) Applicant: Yangtze Memory Technologies Co., Ltd., Wuhan, Hubei 430000 (CN)
(72) Inventor: YU, Kaikai, Wuhan, Hubei 430000 (CN); PENG, Yangqun, Wuhan, Hubei 430000 (CN)
(74) Representative: Lippert Stachow Patentanwälte Rechtsanwälte
(86) International application number: PCT/CN2025/076874
(87) International publication number: WO 2026/170341

(57) **Abstract**

The examples of the present disclosure disclose a memory system and an operating method thereof, and a controller. The memory system comprises a controller and a memory device coupled to the controller, wherein the memory device comprises a plurality of memory cell rows, and each of the memory cell rows comprises a plurality of memory cells, wherein the controller is configured to: determine one row address among a plurality of buffered row addresses as a row hammer address based on count data corresponding to respective row addresses among the plurality of buffered row addresses; generate an adjacent row address adjacent to the row hammer address based on the row hammer address; and send the adjacent row address and a row hammer refresh operation command to the memory device.

## Description

### TECHNICAL FIELD

Examples of the present disclosure relate to the field of semiconductor technologies, and in particular, to a memory system and an operating method thereof, and a controller.

### BACKGROUND

Memory devices are classified into volatile memory and non-volatile memory based on whether stored data is retained during power outages, where volatile memory that loses data during power outages can include static random access memory (SRAM) and dynamic random access memory (DRAM).

Dynamic random access memory requires periodic refreshing to maintain the data stored in the memory cell. In addition, if the same row address in dynamic random access memory is accessed continuously and frequently, when the access accumulates to a certain amount, it may cause the data stored in adjacent memory cell rows to flip, which is generally referred to as a row hammer effect.

### SUMMARY

According to a first aspect of examples of the present disclosure, a memory system is provided, comprising: a controller and a memory device coupled to the controller, wherein the memory device comprises a plurality of memory cell rows, and each of the memory cell rows comprises a plurality of memory cells, wherein the controller is configured to: determine one row address among a plurality of buffered row addresses as a row hammer address based on count data corresponding to respective row addresses among the plurality of buffered row addresses; generate an adjacent row address adjacent to the row hammer address based on the row hammer address, wherein a target memory cell row to which the adjacent row address points is adjacent to a memory cell row to which the row hammer address points; and send the adjacent row address and a row hammer refresh operation command to the memory device, wherein the row hammer refresh operation command is configured to instruct to perform a row hammer refresh operation on the target memory cell row.

According to a second aspect of examples of the present disclosure, an operating method of a memory system is provided, comprising: determining one row address among a plurality of buffered row addresses as a row hammer address based on count data corresponding to respective row addresses among the plurality of buffered row addresses; generating an adjacent row address adjacent to the row hammer address based on the row hammer address, wherein a target memory cell row to which the adjacent row address points is adjacent to a memory cell row to which the row hammer address points; and sending the adjacent row address and a row hammer refresh operation command to a memory device in the memory system, wherein the row hammer refresh operation command is configured to instruct to perform a row hammer refresh operation on the target memory cell row in a plurality of memory cell rows of the memory device.

According to a third aspect of examples of the present disclosure, a controller is provided, wherein the controller is coupled to a memory device comprising a plurality of memory cell rows, each of the memory cell rows comprises a plurality of memory cells; and the controller is configured to: determine one row address among a plurality of buffered row addresses as a row hammer address based on count data corresponding to respective row addresses among the plurality of buffered row addresses; generate an adjacent row address adjacent to the row hammer address based on the row hammer address, wherein a target memory cell row to which the adjacent row address points is adjacent to a memory cell row to which the row hammer address points; and send the adjacent row address and a row hammer refresh operation command to the memory device, wherein the row hammer refresh operation command is configured to instruct to perform a row hammer refresh operation on the target memory cell row.

In an example of the present disclosure, the controller determines one row address among a plurality of buffered row addresses as a row hammer address based on count data corresponding to respective row addresses among the plurality of buffered row addresses, and further generates an adjacent row address, and sends the adjacent row address and a row hammer refresh operation command to the memory device, where the row hammer refresh operation command is configured to instruct to perform a row hammer refresh operation on the target memory cell row to which the adjacent row address points, and the target memory cell row is adjacent to the memory cell row to which the row hammer address points. In this way, through finding the row hammer address and generating the adjacent row address by the controller, the traditional passive prevention within the DRAM can be changed to active prevention by the controller, which can actively prevent the potential occurrence of row hammer errors in the DRAM in advance and actively avoid the occurrence of row hammer problem, which facilitates reducing the possibility that the row hammer problem occurs in the memory device, thereby improving the reliability of the data.

### BRIEF DESCRIPTION OF DRAWINGS

In the drawings, like reference numbers refer to like or similar parts or elements throughout the several drawings unless otherwise specified. These drawings are not necessarily drawn to scale. It should be understood that these drawings depict only some examples disclosed in accordance with the present disclosure and should not be construed as limiting the scope of the present disclosure.
FIG. 1 is a schematic diagram of a system according to an example of the present disclosure.
FIGS. 2A and 2B are schematic diagrams of a memory device according to an example of the present disclosure.
FIG. 3 is a schematic diagram of row hammer effect in a memory array according to an example of the present disclosure.
FIG. 4 is a schematic diagram of a refresh process according to an example of the present disclosure.
FIG. 5 is a schematic diagram of a memory system according to an example of the present disclosure.
FIG. 6 is a schematic flowchart of an operating method of a memory system according to an example of the present disclosure.
FIG. 7 is an operation flowchart of a memory system according to an example of the present disclosure.
FIG. 8 is a schematic diagram of a controller sending an adjacent row address and a row hammer refresh operation command to a memory device according to an example of the present disclosure.

### DETAILED DESCRIPTION

For ease of understanding of the present disclosure, examples of the present disclosure will be described in more detail below with reference to the accompanying drawings. While examples of the present disclosure are shown in the accompanying drawings, it should be understood that the disclosure may be implemented in various forms and should not be limited by the specific examples set forth herein. Rather, these examples are provided to enable a more thorough understanding of the present disclosure and to fully convey the scope of the present disclosure to those skilled in the art.

In the following description, numerous specific details are given in order to provide a more thorough understanding of the present disclosure. It will be apparent to those skilled in the art, however, that the present disclosure may be practiced without one or more of these details. In some examples, to avoid confusion with the present disclosure, some technical features known in the art are not described; that is, not all features of the actual examples may be described herein, and well-known functions and structures are not described in detail.

The present disclosure will be described in more detail hereinafter with reference to the accompanying drawings. Advantages and features of the present disclosure will be more apparent from the following description and claims. It should be noted that the accompanying drawings all adopt a very simplified form and use a non-precise scale, which is only used for the purpose of conveniently and clearly explaining the examples of the present disclosure.

It will be understood that the meaning of "on," "above," and "over" of the present disclosure should be interpreted in a broadest manner such that "on" not only represents "on" something without intervening feature or layer therebetween (i.e., directly on something), but also includes the meaning of "on" something with intervening features or layers therebetween.

In the examples of the present disclosure, the terms "first", "second", "third" and the like are used to distinguish similar objects and not necessarily describe a specific sequence or order.

In the present disclosure, the term "layer" refers to a material portion of a region having a thickness. A layer may extend over the entirety of the underlying or upper structure, or may have a range that is less than that of the underlying or upper structure. Further, a layer can be a region of homogeneous or heterogeneous continuous structure with a thickness less than that of the continuous structure. For example, a layer may be located between the top and bottom surfaces of the continuous structure, or a layer may be between any pair of horizontal surfaces at the top and bottom surfaces of the continuous structure. A layer may extend horizontally, vertically, and/or along sloped surfaces. A layer may include a plurality of sub-layers.

It should be noted that, the technical solutions described in the examples of the present disclosure may be arbitrarily combined without conflict.

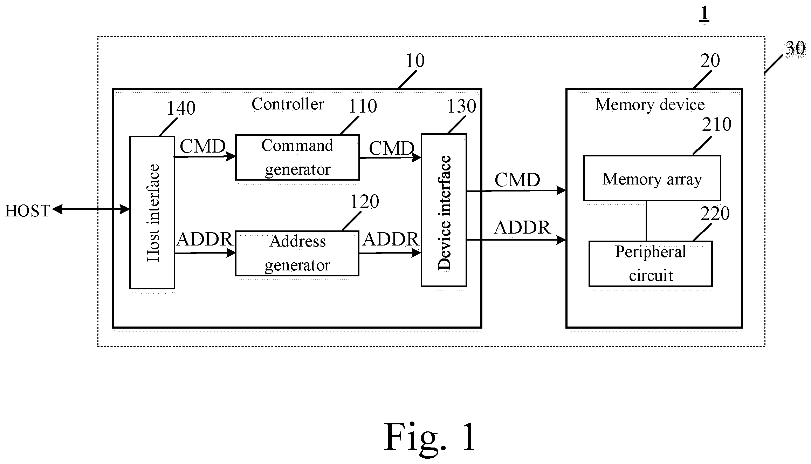

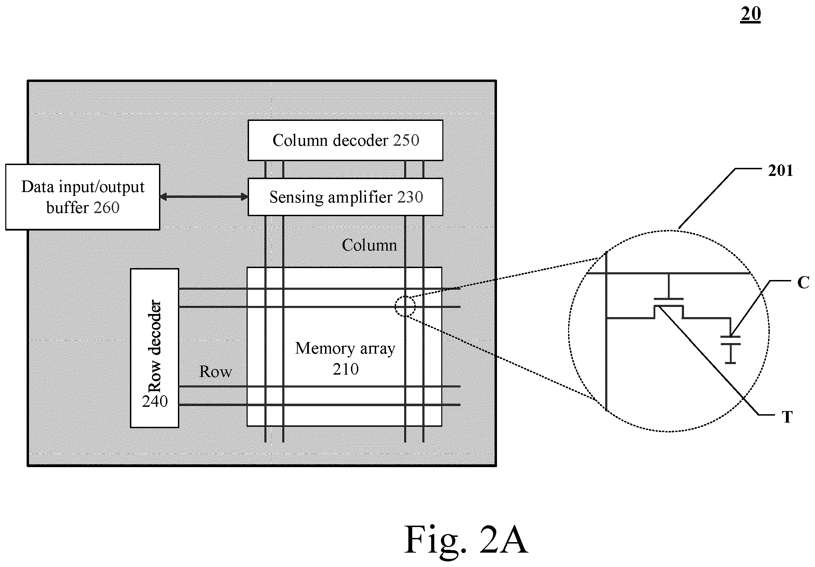

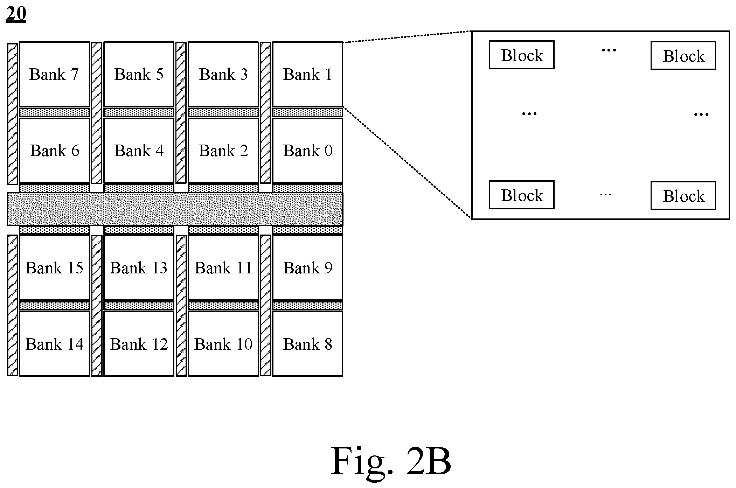

FIG. 1 is a schematic diagram of a system according to an example of the present disclosure, and FIG. 2A and FIG. 2B are schematic diagrams of a memory device according to an example of the present disclosure.

Referring to FIG. 1, the system 1 may include a host and a memory system 30. In an example of the present disclosure, the system 1 may be a mobile phone, a desktop computer, a laptop computer, a tablet computer, a vehicle computer, a game console, a printer, a positioning device, a wearable electronic device, a smart sensor, a virtual reality (VR) device, an augmented reality (AR) device, or any other suitable electronic device having a memory device therein.

The host may be a processor (for example, a central processing unit (CPU) or a system on chip (SoC) (for example, an application processor (AP)) of the electronic device. The memory system 30 has one or more memory devices 20 and a controller 10. The host may be configured to send or receive data to or from the memory device 20. The controller 10 is coupled to the memory device 20 and the host, respectively, and is configured to control the memory device 20. The controller 10 may manage data stored in the memory device 20 and communicate with the host.

The controller 10 may be configured to control operations of the memory device 20, for example, read, write, and refresh operations. In some examples, the controller 10 is further configured to process error correction codes (ECC) regarding data read from or written to the memory device 20. The controller 10 may also perform any other suitable functions, for example, formatting the memory device 20.

In some examples, the controller 10 and the one or more memory devices 20 may be integrated into various types of storage devices, for example, the controller 10 may be integrated into a northbridge of a computer motherboard or integrated directly inside a CPU of a computer, and multiple memory devices 20 may be integrated into a memory bar. That is, the memory system 30 may be implemented and packaged into different types of terminal electronics.

The controller 10 may send data to or receive data from the host, and may send a command CMD and an address ADDR to the memory device 20. The controller 10 may include a command generator 110, an address generator 120, a device interface 130, and a host interface 140. The host interface 140 may receive the command CMD and the address ADDR from the host, the command generator 110 may generate an access command, a refresh command, or the like by decoding the command CMD received from the host, and may provide the access command and the refresh command to the memory device 20 through the device interface 130. The access command may be a signal instructing the memory device 20 to write or read data by accessing a row of a memory array 210 corresponding to the address ADDR. The refresh command may instruct the memory array 210 of the memory device 20 to perform a refresh operation for the stored data.

The address generator 120 in the controller 10 may generate a row address and a column address to be accessed in the memory array 210 by decoding the address ADDR received from the host interface 140. Further, the memory device 20 may generate an address of a bank to be accessed when the memory array 210 includes multiple banks.

Further, the controller 10 may control operations of the memory device, such as write and read, by providing various signals to the memory device 20 via the device interface 130. For example, the controller 10 may provide a write command to the memory device 20. The write command is used to instruct the memory device 20 to perform a write operation to store data into the memory device 20. The memory device 20 may be a random access memory (RAM), such as dynamic random access memory (DRAM), synchronous DRAM (SDRAM), double data rate SDRAM (DDR SDRAM), DDR2 SDRAM, DDR3 SDRAM, phase change RAM (PRAM), magnetic RAM (MRAM), resistive RAM (RRAM), or the like.

Referring to FIG. 1, FIG. 2A, and FIG. 2B, the memory device 20 includes the memory array 210 and a peripheral circuit 220. The memory array 210 includes a plurality of banks, and as an example, FIG. 2B shows 16 banks, i.e., Bank0 to Bank15. Each bank includes a plurality of blocks, each block includes a plurality of memory cell rows and a plurality of memory cell columns, each memory cell row is coupled to a corresponding word line, and each memory cell column is coupled to a corresponding bit line.

The peripheral circuit 220 may include: a control circuit corresponding to each block, for example, a sensing amplifier (SA) 230 and a word-line driver (WLD), and the like; a control circuit corresponding to each bank, for example, a row decoder 240, a column decoder 250, and the like; and a control circuit corresponding to all banks, for example, a data input/output buffer 260, a command buffer, a command decoder, an address buffer, a mode register, and the like.

The peripheral circuit 220 may write data to or read data from the memory array 210 based on the command CMD and the address ADDR received from the controller 10, or may provide a control signal CTRL to the row decoder 240 and the column decoder 230 for refreshing the memory cells included in the memory array 210. In other words, the peripheral circuit 220 may perform all operations to process data in the memory array 210.

Referring to FIG. 2A, the memory device includes at least one DRAM die, each DRAM die includes the memory array 210, the memory array 210 includes a plurality of memory cells 201 arranged in an array, and each memory cell 201 includes a transistor T and a capacitor C. The main working principle of the memory cell is to use the amount of charge stored in the capacitor to represent that whether a binary bit is l or 0. The memory cells arranged in an array may be regarded as a typical mesh structure, where the memory array uses row and column to specify an address. By specifying the intersection of row and column (by specifying the row address and column address of the DRAM), the controller can independently access each of the memory cells in the DRAM die and perform read, write, or refresh operations on the data stored therein.

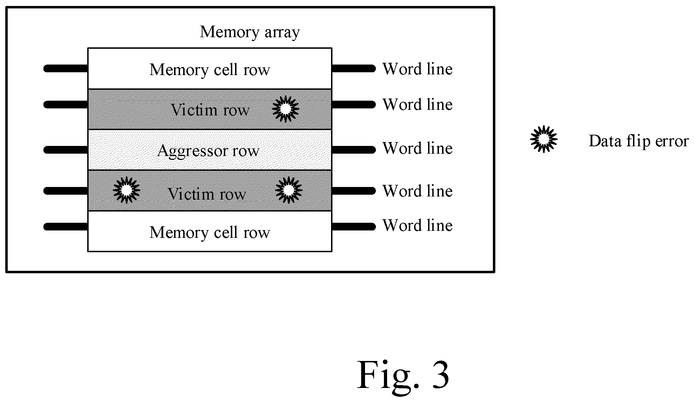

FIG. 3 is a schematic diagram of row hammer effect in a memory array according to an example of the present disclosure. Referring to FIG. 3, the memory array includes a plurality of memory cell rows, each memory cell row is coupled to a corresponding word line. Accessing a memory cell row quickly and continuously over a period of time may cause the occurrence of data flip errors on a memory cell row physically adjacent to the memory cell row being accessed. Generally, a memory cell row being accessed continuously is referred to as an aggressor row, and a physical address of the aggressor row is a row hammer address, as well as a memory cell row physically adjacent to the aggressor row and likely to occur data flip errors is referred to as a victim row, and a physical address of the victim row is an adjacent row address. It should be noted that, each row address corresponds to a word line, and by accessing a target row address in a plurality of row addresses, the word line corresponding to the target row address may be selected or activated.

For the row hammer effect, each DRAM device has a target parameter according to the manufacturing process and the storage density. For example, in a case that a refresh operation is not performed on memory cell rows in the DRAM, if a number of times that a certain memory cell row being continuously accessed is less than a defined target parameter, then data stored in a memory cell row physically adjacent to the memory cell row being continuously accessed is safe and reliable. Otherwise, if a number of times that a certain memory cell row being continuously accessed is greater than or equal to the target parameter, then data stored in a memory cell row physically adjacent to the memory cell row being continuously accessed may occur a data flip error, which is generally referred to as a row hammer error. If a refresh operation is performed timely, before the accessing number that the memory cell row being continuously accessed reaches the target parameter, on the memory cell row physically adjacent to the memory cell row being continuously accessed, then the occurrence of the data flip error on the adjacent memory cell row may be avoided, that is, the occurrence of the row hammer error is avoided, thereby avoiding the occurrence of the row hammer problem. In practical applications, the target parameter of different DRAM manufacturers may be the same or different. The target parameter is typically formulated by the DRAM manufacturer in the development and design phase, and the value of the target parameter may be related to factors such as the manufacturing process used in producing the DRAM, the capacity and size of the die of the DRAM, and the like.

The refresh of DRAM is usually performed in units of rows. In a refresh cycle, a plurality of refresh commands need to be sent to the memory device to perform one refresh operation on all memory arrays in the memory device. For example, the controller sends a refresh command to the memory device, the memory device performs, based on the refresh command, a refresh operation on the memory cell rows to which several row addresses point in all the banks. Refreshing of all the banks can be achieved by continuing to send the refresh command. The refresh cycle depends on the specification of the DRAM, which is typically in milliseconds. For example, if the refresh cycle of the DRAM is 64 milliseconds, then all memory arrays in the memory device need to be refreshed once for every 64 milliseconds.

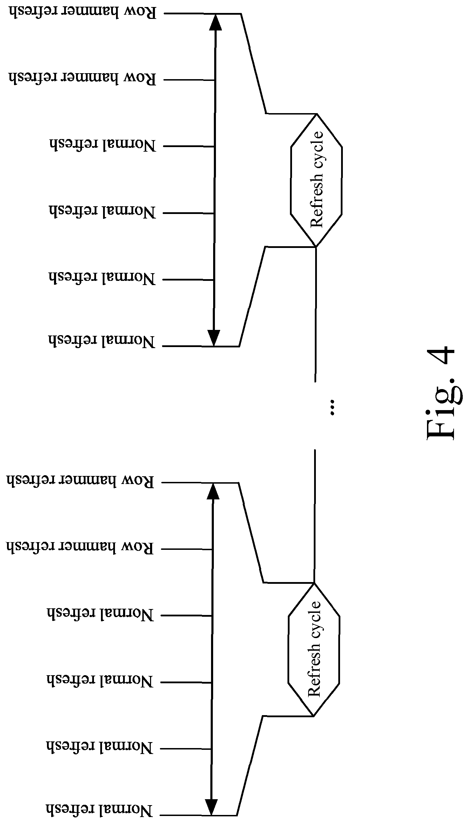

FIG. 4 is a schematic diagram of performing a refresh operation according to an example of the present disclosure. Referring to FIG. 4, the refresh operation mainly includes two parts: a first part is a normal refresh operation (Normal REF) performed to keep the data stored in the memory cells of the DRAM, where one normal refresh operation usually performs the refresh on memory cell rows to which several row addresses point, for example, the normal refresh may be performed on memory cell rows to which 4 row addresses point in each sub-bank; and a second part is a row hammer refresh (RH REF) operation performed to prevent a potential row hammer error of the DRAM from occurring, for example, the row hammer refresh may be performed on memory cell rows to which 2 row addresses point in each sub-bank. In this example, the bank may include a plurality of sub-banks, and each sub-bank includes at least one block.

In the refresh operation of the above technical solution, since the DRAM passively receives the refresh command sent by the controller, the processing of the row hammer problem (for example, finding the row address corresponding to the aggressor row and the row address corresponding to the victim row) is performed by the circuit inside the DRAM. Since the hardware resource inside the DRAM is limited, the potential possibility of occurring the row hammer error in the DRAM is relatively high, and it is difficult to completely avoid the risk of having the row hammer effect.

In addition, the row hammer effect is caused by the current high-density arrangement of DRAM memory cells, which exists in all new generations of DRAM devices (e.g., DDR, LPDDR, GDDR, HBM, etc.). The row hammer effect is a security vulnerability, which is a common problem in all new generations of DRAM devices. By quickly and continuously accessing the memory cell row to which the same row address points, the data of the adjacent memory cell row can be flipped, thereby changing the stored data. The strong attack using the row hammer effect can bypass the current safety mechanism, thereby causing problems, such as the system to be damaged or controlled and memory damage.

Based on one or more of the above technical problems, an example of the present disclosure provides a memory system.

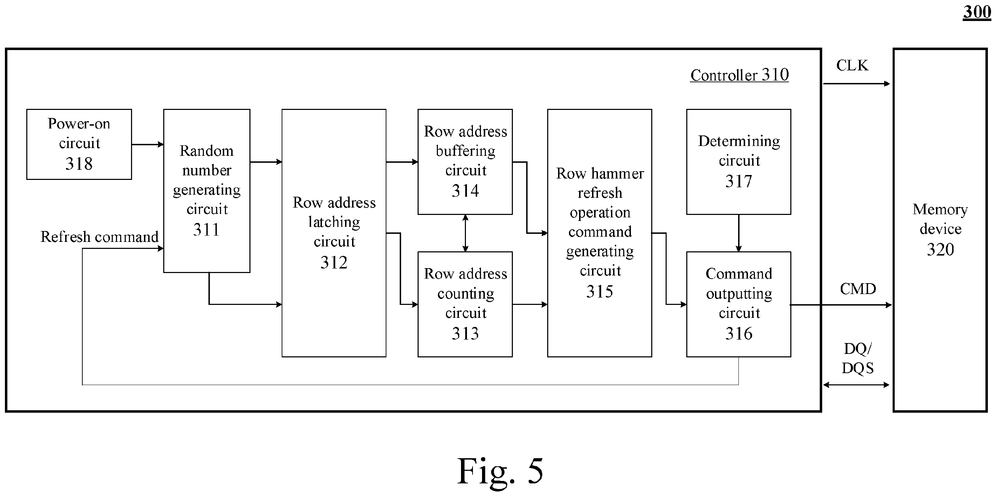

FIG. 5 is a schematic diagram of a memory system according to an example of the present disclosure. Referring to FIG. 5, the memory system 300 includes a memory device 320, and the memory device 320 includes, but is not limited to, DRAM. The memory device 320 may include a plurality of memory cell rows, and the memory cell row include a plurality of memory cells. For the memory device 320, the memory cell row, and the memory cell, please refer to the related descriptions of the memory device 20, the memory cell row, and the memory cell 201 in FIG. 2A and FIG. 2B, respectively.

The memory system 300 further includes a controller 310, where the memory device 320 is coupled to the controller 310. The controller 310 may provide various signals to the memory device 320 through the device interface 130 shown in FIG. 1 to control operations such as write and read. For example, the controller 310 may send at least one of a command signal CMD, a clock signal CLK, and a data signal DQ/data strobe signal DQS to the memory device 320 through the device interface 130 shown in FIG. 1. The controller 310 may also receive the data signal DQ/data strobe signal DQS and the like sent by the memory device 320 through the device interface 130 shown in FIG. 1. It should be noted that the data signal DQ/ data strobe signal DQS are synchronization signals, for example, the controller 310 sends the data signal DQ and the data strobe signal DQS to the memory device 320 synchronously.

In some examples, the controller 310 is configured to: determine one row address among a plurality of buffered row addresses as a row hammer address based on count data corresponding to respective row addresses among the plurality of buffered row addresses; generate an adjacent row address adjacent to the row hammer address based on the row hammer address, wherein a target memory cell row to which the adjacent row address points is adjacent to a memory cell row to which the row hammer address points; and send the adjacent row address and a row hammer refresh operation command to the memory device 320, wherein the row hammer refresh operation command is configured to instruct to perform a row hammer refresh operation on the target memory cell row.

In an example of the present disclosure, the controller 310 may buffer the corresponding row address based on the received access request from the host or based on a plurality of access commands or refresh commands sent to the memory device 320. That is, the controller 310 may: buffer a plurality of row addresses; record the count data corresponding to the respective buffered row addresses; in a case that any one of the plurality of recorded count data reaches the target parameter, determine the row address corresponding to the count data that reaches the target parameter as a row hammer address; generate an adjacent row address adjacent to the row hammer address; and then send the adjacent row address and the row hammer refresh operation command to the memory device 320. As an example, the controller 310 may send a row hammer activation command and a pre-charge command to the memory device 320 to perform a row hammer refresh operation on the target memory cell row. It may be understood that the row hammer refresh operation command includes the row hammer activation command and the pre-charge command.

In other words, the controller 310 may find the row hammer address by means of the count data corresponding to the respective buffered row addresses and further generate the adjacent row address, and send the adjacent row address and the row hammer refresh operation command to the memory device 320, so as to perform the row hammer refresh operation on the target memory cell row to which the adjacent row address points. In this way, through finding the row hammer address and generating the adjacent row address by the controller 310, the traditional passive prevention within the DRAM can be changed to active prevention by the controller 310, which can actively prevent the potential occurrence of row hammer errors in the DRAM in advance and actively avoid the occurrence of row hammer problem, which facilitates reducing the possibility that the row hammer problem occurs in the memory device 320, thereby improving the reliability of the data.

In some examples, the controller 310 is further configured to: send a plurality of activation commands to the memory device 320, wherein one activation command is configured to instruct to activate one target row address; and randomly latch the target row address corresponding to at least one activation command based on a generated random number.

In an example of the present disclosure, the controller 310 may send a plurality of activation commands to the memory device 320. As an example, the controller 310 may generate an access command based on the received access request from the host and send the access command to the memory device 320, wherein the access request includes at least one of a read request and a write request. As another example, the controller 310 may internally generate an access command or a refresh command and send the access command or the refresh command to the memory device 320. In the above two examples, the access command or the refresh command may each include an activation command and other operation commands, for example, a read command, a write command, or the like.

The memory device 320 may activate a corresponding target row address in response to a respective activation command, e.g., the row decoder 240 in FIG. 2A may decode the row address to activate the target row address, and the word line driver may provide a word line driving voltage to the word line corresponding to the target row address based on the target row address. It should be noted that, the target row addresses indicated, by the respective activation command, to be activated may be the same or different, and a plurality of activation commands may be sent to the memory device 320 continuously or intermittently, which is not particularly limited in the present disclosure.

The controller 310 may further generate a random number, and latch the target row address corresponding to the at least one activation command based on the generated random number. For ease of understanding, the following takes the random number being N, a number of activation commands being M, and N and M both being an integer greater than 1 as an example for illustration.

As an example, if N ≤ M < k * N, and k is an integer greater than 1, the controller 310 may latch a target row address corresponding to the N-th activation command, a target row address corresponding to the 2N-th activation command, and a target row address corresponding to the (k -1)-th activation command, respectively. It should be noted that, when the value of k is 2, the controller 310 may only latch the target row address corresponding to the N-th activation command.

In addition, if the M activation commands are sent in multiple batches, for example, the M activation commands are sent in two batches, where M1 activation commands are sent in the first batch, M2 activation commands are sent in the second batch, both M1 and M2 are integers greater than 1, and M1 < N ≤ M1 + M2 ≤ M. The controller 310 may not latch the target row address in a case that the M1 activation commands are sent in the first batch, and latch the target row address corresponding to the respective activation command in a case that the sum of a sequence number of a certain activation command sent in the second batch and M1 is an integer multiple of the random number N.

It may be understood that, in an example of the present disclosure, the plurality of activation commands may also be sent to the memory device 320 in multiple batches, and the controller 310 may accumulate the number of the activation commands sent in multiple batches, and latch the target row address corresponding to the respective activation command in a case that the accumulated number of the activation commands is an integer multiple of the random number.

In an example of the present disclosure, the controller 310 generates a random number, and latches the target row address corresponding to the at least one activation command based on the generated random number, thereby increasing the randomness of the latching of the target row address. In this way, hackers or other users with restricted access may be prevented from performing a row hammer attack by using the security vulnerability of the row hammer effect, which facilitates improving the reliability of the data and the security and stability of the memory system 300.

In some examples, referring to FIG. 5, the controller 310 includes a random number generating circuit 311. The random number generating circuit 311 is configured to generate a random number based on the memory system 300 being powered on.

In an example of the present disclosure, the random number generating circuit 311 may generate any random number in a process of performing power-on initialization by the memory system 300 or in a case that the memory system 300 completes power-on initialization, where the random number may be an integer greater than 1. In addition, the random number generating circuit 311 may further update the generated random number, and the random number after updating and the random number before updating may be the same or different.

As an example, the random number after updating and the random number before updating are different. For example, the random number before updating is N₁, the random number after updating is N₂, both N₁ and N₂ are integers greater than 1, and N₁ and N₂ are different. Before the random number N₁ is updated, the controller 310 may latch the target row address corresponding to the respective activation command in a case that the accumulated number of activation commands is an integer multiple of N₁. After the random number N₁ is updated to N₂, the controller 310 may latch the target row address corresponding to the respective activation command in a case that the accumulated number of activation commands is an integer multiple of N₂. In this way, the latching of the target row address may be more random. That is, the controller 310 does not follow a fixed pattern to latch the target row address, which prevents the hacker or other users with restricted access from finding the fixed pattern for the controller 310 to prevent the row hammer problem, thereby avoiding the hacker or other users with restricted access to perform the row hammer attack by using the fixed pattern.

In some examples, referring to FIG. 5, the controller 310 further includes a power-on circuit 318 coupled to the random number generating circuit 311. The power-on circuit 318 is configured to generate a random number control signal based on the memory system 300 being powered on, where the random number control signal is configured to indicate to generate a random number. The random number generating circuit 311 may receive the random number control signal generated by the power-on circuit 318, and generate a random number. The power-on circuit 318 may also perform a power-on initialization operation based on the memory system 300 being powered on.

In some examples, the random number generating circuit 311 includes a plurality of random number generating sub-circuits and a random number operating circuit, and each of the plurality of random number generating sub-circuits is coupled to the random number operating circuit. The random number generating sub-circuit is configured to: generate an initial random number based on the memory system 300 being powered on; and the random number operating circuit is configured to: perform an operation on the initial random number generated by the respective random number generating sub-circuit to generate a random number.

In an example of the present disclosure, the respective random number generating sub-circuit may generate an initial random number in a process of performing power-on initialization by the memory system 300 or in a case that the memory system 300 completes power-on initialization. The initial random numbers generated by any two of the plurality of random number generating sub-circuits may be the same or different. The random number operating circuit performs operations on the initial random number generated by the respective random number generating sub-circuit to obtain the random number. The operations may include an addition operation, subtraction operation, multiplication operation, division operation, or other operations. In addition, the random number generating sub-circuit may further update the generated initial random number to update the random number.

In some examples, referring to FIG. 5, the controller 310 further includes a row address latching circuit 312 coupled to the random number generating circuit 311. The row address latching circuit 312 is configured to: latch the target row addresses corresponding to the at least one activation command based on the generated random number; where the count of the activation commands corresponding to the latched target row address is an integer multiple of the random number.

In an example of the present disclosure, the row address latching circuit 312 may temporarily store the target row addresses corresponding to the activation command whose count is an integer multiple of the random number in a case that the accumulated number of the activation commands is an integer multiple of the random number (that is, the count of the activation commands is an integer multiple of the random number). In other words, the row address latching circuit 312 may randomly latch the one or more target row addresses based on the random number, thereby increasing the randomness of the latching of the target row address. The row address latching circuit 312 includes any latch that can implement the latching of row address.

As an example, the row address latching circuit 312 may latch the target row address corresponding to the N-th activation command, the target row address corresponding to the 2N-th activation command, and the target row address corresponding to the (k -1)-th activation command, respectively. It should be noted that, in a case that the value of k is 2, the row address latching circuit 312 may only latch the target row address corresponding to the N-th activation command.

In some examples, referring to FIG. 5, the controller 310 further includes a row address counting circuit 313 coupled to the row address latching circuit 312. The row address counting circuit 313 is configured to: increase the count data corresponding to the latched target row address based on the latched target row address being hit.

In an example of the present disclosure, the row address counting circuit 313 may record the count data corresponding to the respective buffered row addresses, and increment the count data corresponding to the latched target row address by 1 in a case that the latched target row address is hit. The latched target row address being hit indicates that the latched target row address is present in the plurality of buffered row addresses.

In some examples, the row address latching circuit 312 is further configured to: compare the latched target row address with the plurality of buffered row addresses to generate a comparison result; where the comparison result is configured to indicate whether the latched target row address is hit.

In an example of the present disclosure, the row address latching circuit 312 may further compare the latched target row address with the plurality of buffered row addresses to generate a comparison result. If the comparison result indicates that the latched target row address is present in the plurality of buffered row addresses, it indicates that the target row address latched in the row address latching circuit 312 is hit. In this case, the row address counting circuit 313 may increase the count data corresponding to the latched target row address, for example, increment the count data corresponding to the latched target row address by 1. Otherwise, if the comparison result indicates that the latched target row address is not present in the plurality of buffered row addresses, it indicates that the latched target row address is missed. In this case, it needs to further determine whether to buffer the missed target row address (that is, the target row address latched in the row address latching circuit 312).

Taking latching the target row address corresponding to the N-th activation command as an example, if the target row address corresponding to the N-th activation command is hit, the row address counting circuit 313 increments the count data corresponding to the hit target row address by 1. Otherwise, if the target row address corresponding to the N-th activation command is missed, it needs to further determine whether to buffer the target row address corresponding to the N-th activation command.

It should be noted that, if the row address latching circuit 312 latches the same target row address for multiple times and the target row address is present in the plurality of buffered row addresses, then the row address counting circuit 313 needs to increment the count data corresponding to the target row address by 1 each time the target row address is latched.

In some examples, referring to FIG. 5, the controller 310 further includes a row address buffering circuit 314 coupled to the row address latching circuit 312 and the row address counting circuit 313, respectively. The row address buffering circuit 314 is configured to: determine whether to buffer the latched target row address based on the latched target row address is missed. The row address counting circuit 313 is further configured to: increase the count data corresponding to the buffered target row address based on the latched target row address being buffered.

In an example of the present disclosure, the row address buffering circuit 314 may buffer a plurality of row addresses, and the plurality of row addresses buffered by the row address buffering circuit 314 are the plurality of buffered row addresses describe above. In a case that the target row address latched by the row address latching circuit 312 is missed, the row address buffering circuit 314 may determine whether to buffer the missed target row address. In a case the row address buffering circuit 314 buffers the missed target row address, that is, the missed target row address is buffered in the row address buffering circuit 314 for the first time, the row address counting circuit 313 may set the count data corresponding to the missed target row address to 1.

In some examples, the row address buffering circuit 314 is configured to: buffer the latched target row address based on the latched target row address is missed and a buffer capacity of the row address buffering circuit 314 is satisfied.

In an example of the present disclosure, in a case that the target row address latched by the row address latching circuit 312 is missed, the row address buffering circuit 314 may determine whether to buffer the missed target row address based on whether the current buffer capacity is satisfied. In an example, if the current buffer capacity of the row address buffering circuit 314 is satisfied, the missed target row address may be buffered. Otherwise, if the current buffer capacity of the row address buffering circuit 314 is not satisfied, it needs to further determine whether to perform buffer capacity management to achieve the buffering of the missed target row address.

It should be noted that, if the current buffer capacity is greater than or equal to the capacity required to buffer the missed target row address, it indicates that the current buffer capacity is satisfied. Otherwise, if the current buffer capacity is less than the capacity required to buffer the missed target row address, it indicates that the current buffer capacity is not satisfied. Current buffer capacity = total capacity of the row address buffering circuit 314 - total capacity of buffered data in the row address buffering circuit 314. It should be understood that the total capacity of the buffered data in the row address buffering circuit 314 is less than or equal to the total capacity of the row address buffering circuit 314.

In some examples, the row address buffering circuit 314 is configured to: determine the count data corresponding to the respective buffered row addresses in the row address buffering circuit 314 based on the latched target row address being missed and the buffer capacity of the row address buffering circuit 314 being not satisfied; and based on the count data corresponding to the at least one row address in the respective buffered row addresses being less than or equal to a first preset threshold, delete the row address with the smallest corresponding count data in the respective buffered row addresses, and buffer the latched target row address.

In an example of the present disclosure, in a case that the latched target row address is missed and the buffer capacity of the row address buffering circuit 314 is not satisfied, the row address buffering circuit 314 may determine whether to perform buffer capacity management, for example, delete at least one buffered row address to increase the buffer capacity. In an example, the row address buffering circuit 314 may determine the count data corresponding to the respective buffered row addresses by means of the row address counting circuit 313. If the count data corresponding to at least one row address is less than or equal to the first preset threshold, it indicates that the number of the row address being accessed is relatively small, and the possibility that the memory cell row to which the row address points is an aggressor row is relatively small, so the row address with the smallest count data may be deleted to increase the buffer capacity, so that the buffer capacity after the row address is deleted is satisfied, thereby achieving the buffering of the missed target row address.

In some examples, the row address buffering circuit 314 is configured to: determine to not buffer the latched target row address based on the count data corresponding to the respective buffered row addresses being greater than the first preset threshold.

In an example of the present disclosure, if the count data corresponding to the respective buffered row addresses is greater than the first preset threshold, it indicates that the number of the respective buffered row addresses being accessed is relatively large, and the possibility that the respective buffered row addresses is an aggressor row is relatively large. While because the latched target row address is missed (the corresponding history count is 0 or not count), it indicates that the number of the missed target row address being accessed is less than the number of the respective buffered row addresses being accessed, and the possibility that the memory cell row to which the missed target row address points is an aggressor row is relatively small. Thus, the missed target row address may not be buffered.

As an example, the row address buffering circuit 314 may rank the count data corresponding to the respective buffered row addresses, and find whether the count data with the smallest rank is less than or equal to the first preset threshold. If the count data with the smallest rank is greater than the first preset threshold, it indicates that the count data corresponding to the respective buffered row addresses is greater than the first preset threshold. Otherwise, if the count data with the smallest rank is less than or equal to the first preset threshold, it indicates that at least one buffered row address may be deleted.

It is apparent that, in other examples, the row address buffering circuit 314 may also compare the count data corresponding to the respective buffered row addresses with the first preset threshold respectively to determine whether to delete at least one buffered row address. It should be noted that the count data corresponding to the respective buffered row addresses may be the same or different, for example, the count data corresponding to the first buffered row address and the count data corresponding to the second buffered row address may be the same or different.

As an example, the first preset threshold may be any integer from 0 to 16, for example, the first preset threshold may be 0, 2, 3, 5, 10, 12, or 16, etc. In practical applications, the first preset threshold may be set reasonably according to actual conditions, which is not particularly limited in the present disclosure.

In some examples, the controller 310 further includes a row hammer refresh operation command generating circuit 315 coupled to the row address buffering circuit 314 and the row address counting circuit 313 respectively. The row hammer refresh operation command generating circuit 315 is configured to: generate a row hammer refresh operation command based on the count data corresponding to one row address in the respective buffered row addresses being greater than or equal to a second preset threshold, wherein the second preset threshold is greater than the first preset threshold.

In an example of the present disclosure, the row hammer refresh operation command generating circuit 315 may determine the row address corresponding to the count data that reaches the second preset threshold as the row hammer address in a case that any one of the plurality of recorded count data reaches the second preset threshold (that is, the target parameter), and generate the adjacent row address based on the row hammer address, so as to generate the row hammer refresh operation command. The adjacent row address and the row hammer refresh operation command may be sent to the memory device 320 through a command outputting circuit 316 or the device interface 130 shown in FIG. 1.

As an example, the second preset threshold may be any integer from 0 to 128, for example, the second preset threshold may be 0, 5, 10, 20, 50, 100, or 128, etc. In practical applications, the second preset threshold may be set reasonably according to actual conditions, which is not particularly limited in the present disclosure.

In some examples, the controller 310 further includes the command outputting circuit 316 coupled to the row hammer refresh operation command generating circuit 315. The command outputting circuit 316 is configured to: output the row hammer refresh operation command based on a data transmission operation on a bank, to which the target memory cell row belongs, having been completed.

In an example of the present disclosure, the command outputting circuit 316 is configured to output the row hammer refresh operation command generated by the row hammer refresh operation command generating circuit 315. In an example, the controller 310 may, before sending the adjacent row address to the memory device 320 and generating the row hammer refresh operation command, first confirm whether the data transmission operation on the bank, to which the target memory cell row belongs, is currently being performed. If the data transmission operation on the bank, to which the target memory cell row belongs, has been completed, the command outputting circuit 316 outputs the row hammer refresh operation command to the memory device 320. The data transmission operation includes at least one of a read operation and a write operation.

It should be noted that the command outputting circuit 316 may further output other operation commands. The command outputting circuit 316 may constitute a part of the device interface 130 shown in FIG. 1, or the command outputting circuit 316 and the device interface 130 shown in FIG. 1 may be two separate circuits in the controller, which is not specifically limited in the present disclosure.

In some examples, the command outputting circuit 316 is further configured to: delay outputting the row hammer refresh operation command based on the data transmission operation on the bank, to which the target memory cell row belongs, is being performed.

In an example of the present disclosure, if the data transmission operation on the bank, to which the target memory cell row belongs, is being performed, the command outputting circuit 316 delays outputting the row hammer refresh operation command to the memory device 320, for example, the row hammer refresh operation command is output after being delayed for a certain period of time.

In some examples, the controller 310 further includes a determining circuit 317 coupled to the command outputting circuit 316. The determining circuit 317 is configured to: determine whether the data transmission operation on the bank, to which the target memory cell row belongs, is being performed.

In an example of the present disclosure, the determining circuit 317 may determine the state of the bank to which the target memory cell row belongs and generate a determination result. If the determination result indicates that the data transmission operation on the bank, to which the target memory cell row belongs, has been completed, it indicates that the row hammer refresh operation may be currently performed on the target memory cell row, so the command outputting circuit 316 outputs the row hammer refresh operation command. Otherwise, if the determination result indicates that the data transmission operation on the bank, to which the target memory cell row belongs, is being performed, it indicates that it needs to wait currently for the data transmission operation on the bank, to which the target memory cell row belongs, to be completed, so the command outputting circuit 316 delays outputting the row hammer refresh operation command.

In some examples, the command outputting circuit 316 is coupled to the random number generating circuit 311. The command outputting circuit 316 is further configured to: output a plurality of refresh commands in a refresh cycle, wherein the refresh command is configured to instruct to perform a refresh operation on at least one of the plurality of memory cell rows. The random number generating circuit 311 is further configured to: update the generated random number based on the refresh command being output.

In an example of the present disclosure, the command outputting circuit 316 may output a plurality of refresh commands (for example, the normal refresh commands shown in FIG. 4) in a refresh cycle, and the memory device 320 performs a refresh operation on at least one of the plurality of memory cell rows based on the refresh command. The refresh operation is typically performed in units of rows, that is, data is rewritten by activating the memory cell row indicated by the refresh command to maintain data stored in the DRAM memory cells. In a case that the command outputting circuit 316 outputs the refresh command, the random number generating circuit 311 may update the generated random number, for example, update the random number N₁ to N₂.

In some examples, the command outputting circuit 316 is coupled to the row address buffering circuit 314. The row address buffering circuit 314 is further configured to: delete the buffered row address based on the refresh command being output. The row address counting circuit 313 is further configured to: reset the count data corresponding to the buffered row address.

In an example of the present disclosure, in a case that the refresh command is output, the row address buffering circuit 314 may delete the buffered row address. For example, the controller 310 sends a plurality of refresh commands to the memory device 320 in the refresh cycle to refresh all the memory cell rows once, and the row address buffering circuit 314 may delete all of the buffered row addresses. In addition, the row address counting circuit 313 may reset the count data corresponding to the buffered row address, for example, reset the count data corresponding to all of the deleted row addresses to 0 or delete the count data corresponding to all of the row addresses.

In some examples, the row hammer refresh operation command includes a row hammer activation command and a pre-charge command. The row hammer activation command is configured to instruct to perform an activation operation on the row address corresponding to the target memory cell row. The pre-charge command is configured to instruct to perform a pre-charge operation on a column address corresponding to a selected memory cell among the plurality of memory cells in the target memory cell row.

In an example of the present disclosure, the memory device 320 may activate the row address corresponding to the target memory cell row in response to the row hammer activation command. For example, the row decoder 240 in FIG. 2A may decode the row address to activate the row address corresponding to the target memory cell row, and the word line driver may provide the word line driving voltage to the word line coupled to the target memory cell row based on the row address corresponding to the target memory cell row to complete the activation operation.

The memory device 320 may also pre-charge the column address corresponding to the target memory cell row in response to the pre-charge command. For example, the column decoder 250 in FIG. 2A may decode the column address to select the column address corresponding to the target memory cell row, and the bit line driver may provide the pre-charge voltage to the bit line coupled to the target memory cell row based on the column address corresponding to the target memory cell row to complete the pre-charge operation.

The examples of the present disclosure provides a memory system, comprising: a controller and a memory device coupled to the controller, wherein the memory device includes a plurality of memory cell rows, each of the memory cell rows includes a plurality of memory cells; and the controller is configured to: determine one row address among a plurality of buffered row addresses as a row hammer address based on count data corresponding to respective row addresses among the plurality of buffered row addresses; generate an adjacent row address adjacent to the row hammer address based on the row hammer address, wherein a target memory cell row to which the adjacent row address points is adjacent to a memory cell row to which the row hammer address points; and send the adjacent row address and a row hammer refresh operation command to the memory device, wherein the row hammer refresh operation command is configured to instruct to perform a row hammer refresh operation on the target memory cell row. In this way, in a first aspect, through finding the row hammer address and generating the adjacent row address by the controller, the traditional passive prevention within DRAM can be changed to active prevention by the controller, which can actively prevent the potential occurrence of row hammer errors in DRAM in advance and actively avoid the occurrence of row hammer problem, which facilitates reducing the possibility that the row hammer problem occurs in the memory device, thereby improving the reliability of the data. In a second aspect, the randomness of the latching of the target row address is increased, and hackers or other users with restricted access may be prevented from performing a row hammer attack by using the security vulnerability of the row hammer effect, which facilitates improving the reliability of the data and the security and stability of the memory system. In a third aspect, the controller hardware automatically realizes the latching, counting and buffering, etc., of the row address, which basically does not require the involvement of the software or changes of any software flow, and has no impact on the use and operation of the external system and the controller. In a fourth aspect, through using the row hammer refresh operation command that combines the row hammer activation command and the pre-charge command to prevent the row hammer problem of DRAM, rather than using a conventional refresh command, the efficiency of DRAM utilization and the flexibility of DRAM utilization can be improved.

Based on the above memory system, an example of the present disclosure provides an operating method of a memory system.

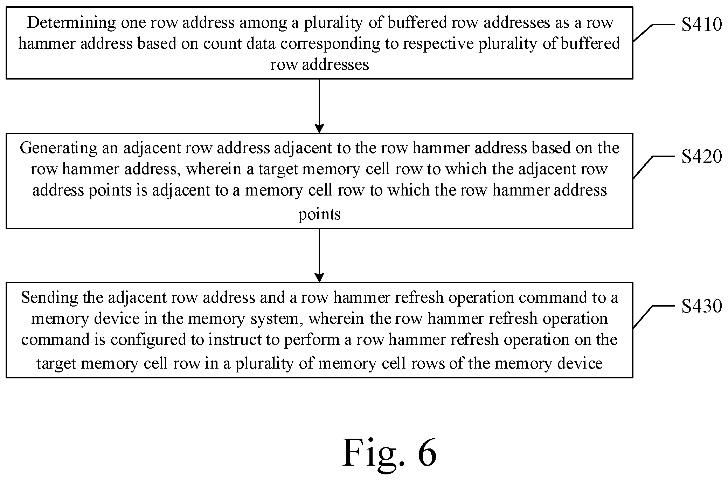

FIG. 6 is a schematic flowchart of an operating method of a memory system according to an example of the present disclosure. It should be noted that the operations shown in FIG. 6 are not exclusive, and other operations may be performed before, after, or between any operations in the illustrated operations; the order of the operations shown in FIG. 6 may be adjusted as desired. Referring to FIG. 6, the operating method includes at least the following operations:
S410: determining one row address among a plurality of buffered row addresses as a row hammer address based on count data corresponding to respective row addresses among the plurality of buffered row addresses;
S420: generating an adjacent row address adjacent to the row hammer address based on the row hammer address, wherein a target memory cell row to which the adjacent row address points is adjacent to a memory cell row to which the row hammer address points; and
S430: sending the adjacent row address and a row hammer refresh operation command to a memory device in the memory system, wherein the row hammer refresh operation command is configured to instruct to perform a row hammer refresh operation on the target memory cell row among a plurality of memory cell rows of the memory device.

In some examples, the operating method further includes: sending a plurality of activation commands to the memory device, wherein one activation command is configured to instruct to activate one target row address; and randomly latching the target row address corresponding to at least one activation command based on a generated random number.

In some examples, the operating method further includes: generating the random number based on the memory system being powered on; latching the target row address corresponding to the at least one activation command based on the generated random number, wherein a count of the activation commands corresponding to the latched target row address is an integer multiple of the random number; and increasing the count data corresponding to the latched target row address based on the latched target row address being hit.

In some examples, the operating method further includes: determining whether to buffer the latched target row address based on the latched target row address being missed; and increasing the count data corresponding to the buffered target row address based on the latched target row address being buffered.

In some examples, determining whether to buffer the latched target row address based on the latched target row address being missed includes: buffering the latched target row address based on the latched target row address being missed and a buffer capacity of the row address buffering circuit being satisfied.

In some examples, determining whether to buffer the latched target row address based on the latched target row address being missed includes: determining the count data corresponding to the respective buffered row addresses, based on the latched target row address being missed and the buffer capacity of the row address buffering circuit being not satisfied; and deleting a row address with a smallest corresponding count data among the respective buffered row addresses and buffering the latched target row address, based on the count data corresponding to the at least one row address among the respective buffered row addresses being less than or equal to a first preset threshold.

In some examples, determining whether to buffer the latched target row address based on the latched target row address being missed further includes: determining to not buffer the latched target row address based on the count data corresponding to the respective buffered row addresses being greater than the first preset threshold.

In some examples, the operating method further includes: generating the row hammer refresh operation command based on the count data corresponding to one row address among the respective buffered row addresses being greater than or equal to a second preset threshold, wherein the second preset threshold is greater than the first preset threshold.

In some examples, the operating method further includes: outputting the row hammer refresh operation command based on a data transmission operation on a bank, to which the target memory cell row belongs, having been completed.

In some examples, the operating method further includes: delaying outputting the row hammer refresh operation command based on the data transmission operation on the bank, to which the target memory cell row belongs, is being performed.

In some examples, the operating method further includes: determining whether the data transmission operation on the bank, to which the target memory cell row belongs, is being performed.

In some examples, the operating method further includes: outputting a plurality of refresh commands in a refresh cycle, wherein each of the refresh commands is configured to instruct to perform a refresh operation on at least one of the plurality of memory cell rows; and updating the generated random number based on the refresh command being output.

In some examples, the operating method further includes: deleting the buffered row addresses based on the refresh command being output; and resetting the count data corresponding to the buffered row addresses.

In some examples, the row hammer refresh operation command includes a row hammer activation command and a pre-charge command, wherein the row hammer activation command is configured to instruct to perform an activation operation on the row address corresponding to the target memory cell row, and the pre-charge command is configured to instruct to perform a pre-charge operation on a column address corresponding to a selected memory cell among the plurality of memory cells in the target memory cell row.

In an example of the present disclosure, the operating method of the memory system may be performed by the controller in the memory system in any one of the above examples, and the technical effects that can be achieved by the memory system in the above examples may also be achieved by the operating method of the memory system, and details are not described herein again. The example of each operation in the operating method in the above examples is described in detail in the related examples of the memory system, and will not be described in detail herein.

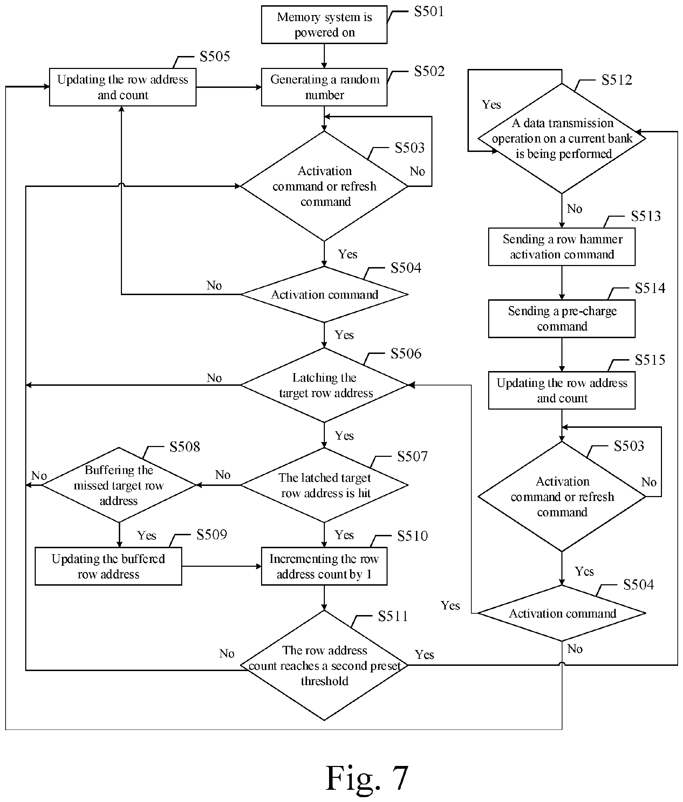

FIG. 7 is an operation flowchart of a memory system according to an example of the present disclosure. For ease of understanding the above operating method, the following describes the operating method of the memory system according to the examples of the present disclosure with reference to FIG. 5 and FIG. 7.

Referring to FIG. 7, in operation S501: the memory system is powered on. In an example, the power-on circuit 318 in FIG. 5 may perform a power-on initialization operation based on the memory system being powered on, and generate a random number control signal and send the random number control signal to the random number generating circuit in FIG. 5.

In operation S502: a random number is generated. In an example, the random number generating circuit in FIG. 5 generates a random number based on the received random number control signal and sends the random number to the row address latching circuit in FIG. 5, where the random number is an integer greater than 1.

In operation S503: it is determined whether the controller sends an activation command or a refresh command to the memory device. In an example, if the controller does not send an activation command or a refresh command to the memory device, the process returns to operation 503, i.e., continuing to wait for the activation command or the refresh command. Otherwise, if the controller sends the activation command or the refresh command to the memory device, operation S504 is performed.

In operation S504: it is determined whether the controller sends the activation command. In an example, if the controller sends the refresh command instead of the activation command, operation S505 is performed. Otherwise, if the controller sends the activation command, operation S506 is performed.

In operation S505: the row address and count are updated. In an example, in a case that the refresh command is output, the row address buffering circuit 314 in FIG. 5 may delete the buffered row address, for example, the controller 310 in FIG. 5 sends a plurality of refresh commands to the memory device 320 in FIG. 5 in a refresh cycle to refresh all the memory cell rows once, and then the row address buffering circuit 314 in FIG. 5 may delete all the buffered row addresses. The row address counting circuit 313 in FIG. 5 may reset the count data corresponding to the buffered row address and update the count data, for example, reset the count data corresponding to all the deleted row addresses to 0 or delete the count data corresponding to all the row addresses. The random number generating circuit 311 in FIG. 5 may also update the generated random number.

In operation S506: it is determined whether to latch the target row address corresponding to the at least one activation command. In an example, if the current count of the activation commands is an integer multiple of the random number, the row address latching circuit 312 in FIG. 5 latches the target row address. Otherwise, if the current count of the activation commands is not an integer multiple of the random number, the row address latching circuit 312 in FIG. 5 does not latch the target row address, and the process returns to operation 503 to continue to wait for the next activation command or refresh command.

In operation S507: it is determined whether the latched target row address is hit. In an example, if the latched target row address is present in the plurality of row addresses buffered by the row address buffering circuit 314 in FIG. 5, it indicates that the latched target row address is hit and operation S510 is performed. Otherwise, if the latched target row address is not present in the plurality of row addresses buffered by the row address buffering circuit 314 in FIG. 5, it indicates that the latched target row address is missed and operation S508 is performed.

In operation S508: it is determined whether to buffer the missed target row address. In an example, if the buffer capacity of the row address buffering circuit 314 in FIG. 5 is satisfied, the missed target row address is buffered and operation S509 is performed. If the buffer capacity of the row address buffering circuit 314 in FIG. 5 is not satisfied, but the count data corresponding to the at least one row address in the respective buffered row addresses is less than or equal to the first preset threshold, the row address with the smallest corresponding count data in the respective buffered row addresses is deleted and operation S509 is performed. If the buffer capacity of the row address buffering circuit 314 in FIG. 5 is not satisfied, and the count data corresponding to the respective buffered row addresses is greater than the first preset threshold, the latched target row address is not buffered and the process returns to operation 503 to continue to wait for the next activation command or refresh command.

In operation S509: the buffered row address is updated. In an example, in a case that the row address buffering circuit 314 in FIG. 5 buffers the missed target row address, the row address buffered in the row address buffering circuit 314 may be updated and operation S510 is performed.

In operation S510: the row address count is incremented by 1. In an example, if the latched target row address is hit, the row address counting circuit 313 in FIG. 5 may increment the count data corresponding to the hit target row address by 1. If the row address buffering circuit 314 in FIG. 5 buffers the missed target row address for the first time, the row address counting circuit 313 in FIG. 5 may set the count data corresponding to the buffered target row address to 1.

In operation S511: it is determined whether the row address count reaches a second preset threshold. In an example, if the count data corresponding to one row address in the respective buffered row addresses is greater than or equal to the second preset threshold, the row address is determined as the row hammer address, and the adjacent row address is generated based on the row hammer address, the row hammer refresh operation command generating circuit 315 in FIG. 5 may generate the row hammer refresh operation command, and operation S512 is performed. Otherwise, if the count data corresponding to the respective buffered row addresses is less than the second preset threshold, the process returns to operation 503 to continues to wait for the next activation command or refresh command.

In operation S512: it is determined whether a data transmission operation on a current bank is being performed. If the data transmission operation on the current bank is being performed, the command outputting circuit 316 in FIG. 5 delays outputting the row hammer refresh operation command. Otherwise, if the data transmission operation on the current bank has been completed, operation S513 is performed. The current bank is a bank to which the target memory cell row belongs, and the target memory cell row is adjacent to the memory cell row to which the row hammer address points.

In operation S513: a row hammer activation command is sent. In an example, the command outputting circuit 316 in FIG. 5 outputs the row hammer refresh operation command, the row hammer refresh operation command includes a row hammer activation command, the row hammer activation command is configured to instruct to perform an activation operation on the row address corresponding to the target memory cell row. After the activation operation is completed, operation S514 is performed.

In operation S514: a pre-charge command is sent. The row hammer refresh operation command further includes the pre-charge command, the pre-charge command is configured to instruct to perform a pre-charge operation on a column address corresponding to a selected memory cell among the plurality of memory cells in the target memory cell row. After the pre-charge operation is completed, operation S515 is performed.

In operation S515: the row address and count are updated. In an example, after the row hammer refresh operation on the target memory cell row is completed, the row address buffering circuit 314 in FIG. 5 may delete the row hammer address and update the buffered row address. The row address counting circuit 313 in FIG. 5 may delete the count data corresponding to the row hammer address. After the row hammer refresh operation is completed, the process continues to wait for the next activation command or refresh command.

It may be understood that, through repeatedly performing the above operations S501 to S515, the controller may deal with the row hammer problem. That is, the controller finds the row hammer address and generates the adjacent row address, thus the traditional passive prevention within DRAM can be changed to active prevention by the controller, which can actively prevent the potential occurrence of row hammer errors in DRAM in advance and actively avoid the occurrence of row hammer problem, facilitating reducing the possibility that the row hammer problem occurs in the memory device, thereby improving the reliability of the data.

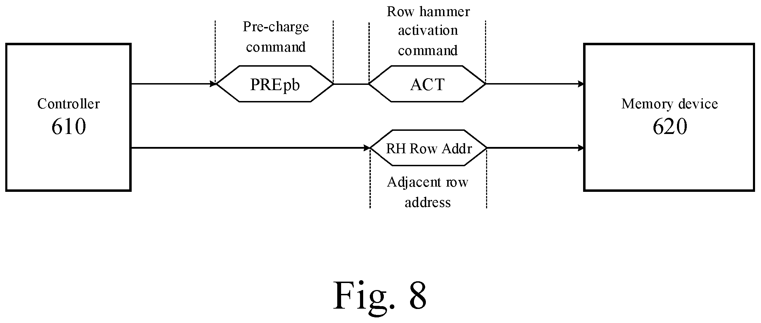

FIG. 8 is a schematic diagram of a controller sending an adjacent row address and a row hammer refresh operation command to a memory device according to an example of the present disclosure.

Referring to FIG. 8, a controller 610 sends an adjacent row address RH Row Addr and a row hammer refresh operation command to a memory device 620, where the row hammer refresh operation command includes a row hammer activation command ACT and a pre-charge command PREpb.

In an example, the memory device 620 may perform an activation operation on a target memory cell row to which the adjacent row address points based on the row hammer activation command ACT, where the activated target memory cell row is adjacent to the memory cell row to which the row hammer address points. After the activation operation is completed, the memory device 620 may further perform a pre-charge operation on a column address corresponding to the target memory cell row based on the pre-charge command PREpb.

As an example, the controller 610 generates two adjacent row addresses RH Row addr based on the row hammer address, where the generated two adjacent row addresses RH Row addr may be (Aggressor Row Address + 1) and (Aggressor Row Address -1), respectively.

The controller 610 sends a first row hammer activation command ACT and a first adjacent row address (Aggressor Row Address + 1) to the memory device 620 to activate (or turn on) the first adjacent row address (Aggressor Row Address + 1). After activating the first adjacent row address (Aggressor Row Address + 1), the controller 610 sends a first pre-charge command PREpb to turn off the first adjacent row address (Aggressor Row Address + 1) to complete the row hammer refresh of the first target memory cell row to which the first adjacent row address (Aggressor Row Address + 1) points.

The controller 610 sends a second row hammer activation command ACT and a second adjacent row address (Aggressor Row Address - 1) to the memory device 620 to activate (or turn on) the second adjacent row address (Aggressor Row Address - 1). After activating the second adjacent row address (Aggressor Row Address - 1), the controller 610 sends a second pre-charge command PREpb to turn off the second adjacent row address (Aggressor Row Address - 1) to complete the row hammer refresh of the second target memory cell row to which the second adjacent row address (Aggressor Row Address - 1) points.

In another example, the row hammer refresh of the second target memory cell row may also be performed first, and then the row hammer refresh of the first target memory cell row is performed. The order of performing the row hammer refresh on the first target memory cell row and the second target memory cell row is not specifically limited in the examples of the present disclosure.

It should be noted that, although the controller 610 generates two adjacent row addresses, however if the memory cell row to which the row hammer address points is the topmost memory cell row or the bottommost memory cell row among the plurality of memory cell rows, the memory device 620 may perform the row hammer refresh on only one of the adjacent row addresses. That is, the controller 610 sends the first adjacent row address (Aggressor Row Address + 1) and the second adjacent row address (Aggressor Row Address -1) to the memory device 620, and the memory device 620 may perform the row hammer refresh only on the first adjacent row address (Aggressor Row Address + 1) or the second adjacent row address (Aggressor Row Address -1) that is adjacent to the row hammer address.

Based on the above memory system, an example of the present disclosure provides a controller, the controller is coupled to a memory device, wherein the memory device includes a plurality of memory cell rows, and each of the memory cell row includes a plurality of memory cells; and the controller is configured to: determine one row address among a plurality of buffered row addresses as a row hammer address based on count data corresponding to respective row addresses among the plurality of buffered row addresses; generate an adjacent row address adjacent to the row hammer address based on the row hammer address, wherein a target memory cell row to which the adjacent row address points is adjacent to a memory cell row to which the row hammer address points; and send the adjacent row address and a row hammer refresh operation command to the memory device, wherein the row hammer refresh operation command is configured to instruct to perform a row hammer refresh operation on the target memory cell row.

In some examples, the controller is further configured to: send a plurality of activation commands to the memory device, wherein one activation command is configured to instruct to activate one target row address; and randomly latch the target row address corresponding to at least one activation command based on a generated random number.

In some examples, the controller includes a random number generating circuit; and the random number generating circuit is configured to: generate the random number based on the memory system being powered on.

In some examples, the controller further includes a row address latching circuit coupled to the random number generating circuit; and the row address latching circuit is configured to: latch the target row address corresponding to the at least one activation command based on the generated random number, wherein a count of the activation commands corresponding to the latched target row address is an integer multiple of the random number.

In some examples, the controller further includes a row address counting circuit coupled to the row address latching circuit; and the row address counting circuit is configured to: increase the count data corresponding to the latched target row address based on the latched target row address being hit.

In some examples, the controller further includes a row address buffering circuit coupled to the row address latching circuit and the row address counting circuit, respectively; the row address buffering circuit is configured to: determine whether to buffer the latched target row address based on the latched target row address being missed; and the row address counting circuit is further configured to: increase the count data corresponding to the buffered target row address based on the latched target row address being buffered.

In some examples, the row address buffering circuit is configured to: buffer the latched target row address based on the latched target row address being missed and a buffer capacity of the row address buffering circuit being satisfied.

In some examples, the row address buffering circuit is configured to: determine the count data corresponding to the respective buffered row addresses in the row address buffering circuit, based on the latched target row address being missed and the buffer capacity of the row address buffering circuit being not satisfied; and delete a row address with a smallest corresponding count data in the respective buffered row addresses and buffer the latched target row address, based on the count data corresponding to the at least one row address among the respective buffered row addresses being less than or equal to a first preset threshold.

In some examples, the row address buffering circuit is configured to: determine to not buffer the latched target row address based on the count data corresponding to the respective buffered row addresses being greater than the first preset threshold.

In some examples, the controller further includes a row hammer refresh operation command generating circuit coupled to the row address buffering circuit and the row address counting circuit, respectively; and the row hammer refresh operation command generating circuit is configured to: generate the row hammer refresh operation command based on the count data corresponding to one row address among the respective buffered row addresses being greater than or equal to a second preset threshold, wherein the second preset threshold is greater than the first preset threshold.

In some examples, the controller further includes a command outputting circuit coupled to the row hammer refresh operation command generating circuit; and the command outputting circuit is configured to: output the row hammer refresh operation command based on a data transmission operation on a bank, to which the target memory cell row belongs, having been completed.

In some examples, the command outputting circuit is further configured to: delay outputting the row hammer refresh operation command based on the data transmission operation on the bank, to which the target memory cell row belongs, is being performed.

In some examples, the controller further includes a determining circuit coupled to the command outputting circuit; and the determining circuit is configured to: determine whether the data transmission operation on the bank, to which the target memory cell row belongs, is being performed.

In some examples, the command outputting circuit is coupled to the random number generating circuit; the command outputting circuit is further configured to: output a plurality of refresh commands in a refresh cycle, wherein each of the refresh commands is configured to instruct to perform a refresh operation on at least one of the plurality of memory cell rows; and the random number generating circuit is further configured to: update the generated random number based on the refresh command being output.

In some examples, the command outputting circuit is coupled to the row address buffering circuit; the row address buffering circuit is further configured to: delete the buffered row addresses based on the refresh command being output; and the row address counting circuit is further configured to: reset the count data corresponding to the buffered row addresses.

In some examples, the row hammer refresh operation command includes a row hammer activation command and a pre-charge command; wherein the row hammer activation command is configured to instruct to perform an activation operation on the row address corresponding to the target memory cell row, and the pre-charge command is configured to instruct to perform a pre-charge operation on a column address corresponding to a selected memory cell among the plurality of memory cells in the target memory cell row.

In an example of the present disclosure, the controller may be the same as the controller in the memory system in any one of the above examples, and technical effects that can be achieved by the memory system in the above examples may also be achieved by the controller, and details are not described herein again. The circuits in the controller in the above examples are described in detail in the related examples of the memory system, and will not be described in detail herein.

The above descriptions are only examples of the present disclosure, but the protection scope of the present disclosure is not limited thereto. Changes or replacements that may be easily conceived by any person skilled in the art within the technical scope of the present disclosure should be covered within the protection scope of the present disclosure.

## Claims

1. A memory system, comprising:
a controller; and
a memory device coupled to the controller, wherein the memory device comprises a plurality of memory cell rows, and each of the memory cell rows comprises a plurality of memory cells;
wherein the controller is configured to:
determine one row address among a plurality of buffered row addresses as a row hammer address based on count data corresponding to respective row addresses among the plurality of buffered row addresses;
generate an adjacent row address adjacent to the row hammer address based on the row hammer address, wherein a target memory cell row to which the adjacent row address points is adjacent to a memory cell row to which the row hammer address points; and
send the adjacent row address and a row hammer refresh operation command to the memory device, wherein the row hammer refresh operation command is configured to instruct to perform a row hammer refresh operation on the target memory cell row.

2. The memory system of claim 1, wherein the controller is further configured to:
send a plurality of activation commands to the memory device, wherein one of the activation commands is configured to instruct to activate one target row address; and
randomly latch the target row address corresponding to at least one of the activation commands based on a generated random number.

3. The memory system of claim 2, wherein the controller comprises:
a random number generating circuit configured to:
generate the random number based on the memory system being powered on;
a row address latching circuit coupled to the random number generating circuit and configured to:
latch the target row address corresponding to the at least one of the activation commands based on the generated random number, wherein a count of the activation commands corresponding to the latched target row address is an integer multiple of the random number; and
a row address counting circuit coupled to the row address latching circuit and configured to:
increase the count data corresponding to the latched target row address based on the latched target row address being hit.

4. The memory system of claim 3, wherein the controller further comprises:
a row address buffering circuit coupled to the row address latching circuit and the row address counting circuit respectively and configured to:
determine whether to buffer the latched target row address based on the latched target row address being missed,
wherein the row address counting circuit is further configured to:
increase the count data corresponding to the buffered target row address based on the latched target row address being buffered.

5. The memory system of claim 4, wherein the row address buffering circuit is configured to:
buffer the latched target row address based on the latched target row address being missed and a buffer capacity of the row address buffering circuit being satisfied.

6. The memory system of claim 4, wherein the row address buffering circuit is configured to:
determine the count data corresponding to the respective buffered row addresses in the row address buffering circuit, based on the latched target row address being missed and a buffer capacity of the row address buffering circuit being not satisfied; and
delete a row address with a smallest corresponding count data among the respective buffered row addresses and buffer the latched target row address, based on the count data corresponding to the at least one row address among the respective buffered row addresses being less than or equal to a first preset threshold.

7. The memory system of claim 6, wherein the row address buffering circuit is configured to:
determine to not buffer the latched target row address based on the count data corresponding to the respective buffered row addresses being greater than the first preset threshold.

8. The memory system of claim 6, wherein the controller further comprises:
a row hammer refresh operation command generating circuit coupled to the row address buffering circuit and the row address counting circuit respectively and configured to:
generate the row hammer refresh operation command based on the count data corresponding to one row address among the respective buffered row addresses being greater than or equal to a second preset threshold, wherein the second preset threshold is greater than the first preset threshold.

9. The memory system of claim 8, wherein the controller further comprises:
a command outputting circuit coupled to the row hammer refresh operation command generating circuit and configured to:
output the row hammer refresh operation command based on a data transmission operation on a bank, to which the target memory cell row belongs, having been completed.

10. The memory system of claim 9, wherein the command outputting circuit is further configured to:
delay outputting the row hammer refresh operation command based on the data transmission operation on the bank, to which the target memory cell row belongs, is being performed.

11. The memory system of claim 9, wherein the controller further comprises:
a determining circuit coupled to the command outputting circuit and configured to:
determine whether the data transmission operation on the bank, to which the target memory cell row belongs, is being performed.

12. The memory system of claim 9, wherein
the command outputting circuit is coupled to the random number generating circuit;
the command outputting circuit is further configured to:
output a plurality of refresh commands in a refresh cycle, wherein each of the refresh commands is configured to instruct to perform a refresh operation on at least one of the plurality of memory cell rows; and
the random number generating circuit is further configured to:
update the generated random number based on the refresh command being output.

13. The memory system of claim 12, wherein
the command outputting circuit is coupled to the row address buffering circuit;
the row address buffering circuit is further configured to:
delete the buffered row addresses based on the refresh command being output; and
the row address counting circuit is further configured to:
reset the count data corresponding to the buffered row addresses.

14. The memory system of claim 1, wherein
the row hammer refresh operation command comprises a row hammer activation command and a pre-charge command;
the row hammer activation command is configured to instruct to perform an activation operation on the row address corresponding to the target memory cell row; and
the pre-charge command is configured to instruct to perform a pre-charge operation on a column address corresponding to a selected memory cell among the plurality of memory cells in the target memory cell row.

15. The memory system of claim 1, wherein the memory device comprises a dynamic random access memory.

16. An operating method of a memory system, comprising:
determining one row address among a plurality of buffered row addresses as a row hammer address based on count data corresponding to respective row addresses among the plurality of buffered row addresses;
generating an adjacent row address adjacent to the row hammer address based on the row hammer address, wherein a target memory cell row to which the adjacent row address points is adjacent to a memory cell row to which the row hammer address points; and
sending the adjacent row address and a row hammer refresh operation command to a memory device in the memory system, wherein the row hammer refresh operation command is configured to instruct to perform a row hammer refresh operation on the target memory cell row among a plurality of memory cell rows of the memory device.

17. The operating method of claim 16, further comprising:
sending a plurality of activation commands to the memory device, wherein one of the activation commands is configured to instruct to activate one target row address; and
randomly latching the target row address corresponding to at least one of the activation commands based on a generated random number.

18. The operating method of claim 17, further comprising:
generating the random number based on the memory system being powered on;
latching the target row address corresponding to the at least one of the activation commands based on the generated random number, wherein a count of the activation commands corresponding to the latched target row address is an integer multiple of the random number; and
increasing the count data corresponding to the latched target row address based on the latched target row address being hit.

19. The operating method of claim 18, further comprising:
determining whether to buffer the latched target row address based on the latched target row address being missed; and
increasing the count data corresponding to the buffered target row address based on the latched target row address being buffered.

20. The operating method of claim 19, wherein determining whether to buffer the latched target row address based on the latched target row address being missed comprises:
buffering the latched target row address based on the latched target row address being missed and a buffer capacity of the row address buffering circuit being satisfied.

21. The operating method of claim 19, wherein determining whether to buffer the latched target row address based on the latched target row address being missed comprises:
determining the count data corresponding to the respective buffered row addresses, based on the latched target row address being missed and a buffer capacity of the row address buffering circuit being not satisfied; and
deleting a row address with a smallest corresponding count data among the respective buffered row addresses and buffering the latched target row address, based on the count data corresponding to the at least one row address among the respective buffered row addresses being less than or equal to a first preset threshold.

22. The operating method of claim 21, wherein determining whether to buffer the latched target row address based on the latched target row address being missed further comprises:
determining to not buffer the latched target row address based on the count data corresponding to the respective buffered row addresses being greater than the first preset threshold.

23. The operating method of claim 21, further comprising:
generating the row hammer refresh operation command based on the count data corresponding to one row address among the respective buffered row addresses being greater than or equal to a second preset threshold, wherein the second preset threshold is greater than the first preset threshold.

24. The operating method of claim 22, further comprising:
outputting the row hammer refresh operation command based on a data transmission operation on a bank, to which the target memory cell row belongs, having been completed.

25. The operating method of claim 24, further comprising:
delaying outputting the row hammer refresh operation command based on the data transmission operation on the bank, to which the target memory cell row belongs, is being performed.

26. The operating method of claim 24, further comprising:
determining whether the data transmission operation on the bank, to which the target memory cell row belongs, is being performed.

27. The operating method of claim 24, further comprising:
outputting a plurality of refresh commands in a refresh cycle, wherein each of the refresh commands is configured to instruct to perform a refresh operation on at least one of the plurality of memory cell rows; and
updating the generated random number based on the refresh command being output.

28. The operating method of claim 27, further comprising:
deleting the buffered row addresses based on the refresh command being output; and
resetting the count data corresponding to the buffered row addresses.

29. The operating method of claim 16, wherein
the row hammer refresh operation command comprises a row hammer activation command and a pre-charge command;
the row hammer activation command is configured to instruct to perform an activation operation on the row address corresponding to the target memory cell row; and
the pre-charge command is configured to instruct to perform a pre-charge operation on a column address corresponding to a selected memory cell among the plurality of memory cells in the target memory cell row.

30. A controller, wherein the controller is coupled to a memory device comprising a plurality of memory cell rows, each of the memory cell rows comprises a plurality of memory cells, and the controller is configured to:
determine one row address among a plurality of buffered row addresses as a row hammer address based on count data corresponding to respective row addresses among the plurality of buffered row addresses;
generate an adjacent row address adjacent to the row hammer address based on the row hammer address, wherein a target memory cell row to which the adjacent row address points is adjacent to a memory cell row to which the row hammer address points; and
send the adjacent row address and a row hammer refresh operation command to the memory device, wherein the row hammer refresh operation command is configured to instruct to perform a row hammer refresh operation on the target memory cell row.

31. The controller of claim 30, further configured to:
send a plurality of activation commands to the memory device, wherein one of the activation commands is configured to instruct to activate one target row address; and
randomly latch the target row address corresponding to at least one of the activation commands based on a generated random number.

32. The controller of claim 31, comprising:
a random number generating circuit configured to:
generate the random number based on the controller being powered on;
a row address latching circuit coupled to the random number generating circuit and configured to:
latch the target row address corresponding to the at least one of the activation commands based on the generated random number, wherein a count of the activation commands corresponding to the latched target row address is an integer multiple of the random number; and
a row address counting circuit coupled to the row address latching circuit and configured to:
increase the count data corresponding to the latched target row address based on the latched target row address being hit.

33. The controller of claim 32, further comprising:
a row address buffering circuit coupled to the row address latching circuit and the row address counting circuit respectively and configured to:
determine whether to buffer the latched target row address based on the latched target row address being missed,
wherein the row address counting circuit is further configured to:
increase the count data corresponding to the buffered target row address based on the latched target row address being buffered.

34. The controller of claim 33, wherein the row address buffering circuit is configured to:
buffer the latched target row address based on the latched target row address being missed and a buffer capacity of the row address buffering circuit being satisfied.

35. The controller of claim 33, wherein the row address buffering circuit is configured to:
determine the count data corresponding to the respective buffered row addresses in the row address buffering circuit, based on the latched target row address being missed and a buffer capacity of the row address buffering circuit being not satisfied; and
delete a row address with a smallest corresponding count data among the respective buffered row addresses and buffer the latched target row address, based on the count data corresponding to the at least one row address among the respective buffered row addresses being less than or equal to a first preset threshold.

36. The controller of claim 35, wherein the row address buffering circuit is configured to:
determine to not buffer the latched target row address based on the count data corresponding to the respective buffered row addresses being greater than the first preset threshold.

37. The controller of claim 35, further comprising:
a row hammer refresh operation command generating circuit coupled to the row address buffering circuit and the row address counting circuit respectively and configured to:
generate the row hammer refresh operation command based on the count data corresponding to one row address among the respective buffered row addresses being greater than or equal to a second preset threshold, wherein the second preset threshold is greater than the first preset threshold.

38. The controller of claim 37, further comprising:
a command outputting circuit coupled to the row hammer refresh operation command generating circuit and configured to:
output the row hammer refresh operation command based on a data transmission operation on a bank, to which the target memory cell row belongs, having been completed.

39. The controller of claim 38, wherein the command outputting circuit is further configured to:
delay outputting the row hammer refresh operation command based on the data transmission operation on the bank, to which the target memory cell row belongs, is being performed.

40. The controller of claim 38, further comprising:
a determining circuit coupled to the command outputting circuit and configured to:
determine whether the data transmission operation on the bank, to which the target memory cell row belongs, is being performed.

41. The controller of claim 38, wherein
the command outputting circuit is coupled to the random number generating circuit;
the command outputting circuit is further configured to:
output a plurality of refresh commands in a refresh cycle, wherein each of the refresh commands is configured to instruct to perform a refresh operation on at least one of the plurality of memory cell rows; and
the random number generating circuit is further configured to:
update the generated random number based on the refresh command being output.

42. The controller of claim 41, wherein
the command outputting circuit is coupled to the row address buffering circuit;
the row address buffering circuit is further configured to:
delete the buffered row addresses based on the refresh command being output; and
the row address counting circuit is further configured to:
reset the count data corresponding to the buffered row addresses.

43. The controller of claim 30, wherein
the row hammer refresh operation command comprises a row hammer activation command and a pre-charge command;
the row hammer activation command is configured to instruct to perform an activation operation on the row address corresponding to the target memory cell row; and
the pre-charge command is configured to instruct to perform a pre-charge operation on a column address corresponding to a selected memory cell among the plurality of memory cells in the target memory cell row.
